# EUROPEAN PATENT SPECIFICATION

(11) **EP 3 624 318 B1**
(45) Date of publication and mention of the grant of the patent: **17.11.2021**
(21) Application number: 18194080.0
(22) Date of filing: 12.09.2018
(51) Int. Cl.: H02M 1/08, H03K 17/691, H02M 1/00

(54) **TRANSMITTING ENERGY AND A DATA SIGNAL VIA A TRANSFORMER**
ÜBERTRAGUNG VON ENERGIE UND EINES DATENSIGNALS ÜBER EINEN TRANSFORMATOR
TRANSMISSION D'ÉNERGIE ET D'UN SIGNAL DE DONNÉES PAR L'INTERMÉDIAIRE D'UN TRANSFORMATEUR

(43) Date of publication of application: 18.03.2020
(73) Proprietor: ABB Schweiz AG, 5400 Baden (CH)
(72) Inventor: Schmid, Patrick, 5200 Brugg (CH); Knapp, Gerold, 5420 Ehrendingen (CH); Lobsiger, Yanick, 5000 Aarau (CH); Friedli, Thomas, 5400 Baden (CH); Egli, Andreas, 4051 Basel (CH)
(74) Representative: Qip Patentanwälte Dr. Kuehn & Partner mbB

(56) References cited:
- US-A- 5 206 540
- US-A1- 2009 212 759
- US-A1- 2010 117 752
- US-A1- 2014 055 172
- US-A1- 2014 062 551
- MATTHIAS ROSE ET AL: "Adaptive dv/dt and di/dt control for isolated gate power devices", ENERGY CONVERSION CONGRESS AND EXPOSITION (ECCE), 2010 IEEE, IEEE, PISCATAWAY, NJ, USA, 12 September 2010 (2010-09-12), pages 927-934, XP031787108, ISBN: 978-1-4244-5286-6
- SEIDEL ACHIM ET AL: "Isolated 100% PWM gate driver with auxiliary energy and bidirectional FM/AM signal transmission via single transformer", 2015 IEEE APPLIED POWER ELECTRONICS CONFERENCE AND EXPOSITION (APEC), IEEE, 15 March 2015 (2015-03-15), pages 2581-2584, XP032774954, DOI: 10.1109/APEC.2015.7104715 [retrieved on 2015-05-08]

## Description

### FIELD OF THE INVENTION

The invention relates to a method of transmitting energy and a data signal via a transformer, a data and energy transmission system and to a control device for controlling a power semiconductor device.

### BACKGROUND OF THE INVENTION

Electrical converter systems are usually composed of a plurality of power semiconductor modules, which during operation of the converter are on high potential. The switching signals, which are generated in a central controller, have to be transmitted to gate drivers of the power semiconductor modules, which decode these signals and apply appropriate gate voltage and currents to the power semiconductor switches of the modules.

For electrically isolating the central controller from the module, pulse transformers and optical links can be used.

Due to the high isolation requirements, optical links are mainly used in medium voltage converters, where the central controller is directly connected with a secondary side of the gate drivers. Therefore, usually single channel gate drivers are used, which, however, may have disadvantages, such as large space requirements, complex wiring of optical lines and supply lines, a large number of optical interfaces in the central controller and high system cost.

In low voltage converters, due to the lower isolations requirements, transformers are used for energy and signal transmission. Due to this, multiple channel gate drivers may be used, which may result in lower system costs. However, a signal transmission via a transformer, which is also used for transmitting energy, may have a great jitter, since the signal transmission has to consider the energy transmission, which sets limits to signal generation. In particular for medium voltage and high voltage power semiconductor devices, a high jitter may cause problems due to unsynchronized switching, may deteriorate the stability of control loops, and may create high switching losses and faster degrading of power semiconductor switches.

WO 2007 128 675 A1 shows an energy and signal transmission device for a power electronics device, which transfers electrical power via a transformer. A signal may be transferred from a primary side to a secondary side of the transformer via varying the length of amplitudes of an input voltage of the transformer. A further signal may be transferred from the secondary side to the primary side by varying a secondary side current with a switch.

DE 10 2010 028 817 A1 describes a method for transmitting a binary signal via a transformer to a power semiconductor. The binary signal is encoded in pulse packets in an input voltage of the transformer.

US 2014/055 172 A1 shows a switch driving circuit, in which a gate signal is transmitted via a transformer. It is shown that additional pulses caused by noise may be present between pulses encoding the gate signal.

US 2014/062 551 A1 describes that pulse width modulated pulses may be delayed with a delay-locked loop to generate a time-invariant shift having a precision finer than a system clock.

The article of Matthias Rose et al. "Adaptive dv/dt and di/dt control for isolated gate power devices", Energy Conversion Congress and Exposition (ECCE), 2010 IEEE, IEEE, Piscataway, NJ, USA, 12 September 2010, shows a gate control system, which is adapted for compensating delays of a driver and controls section.

A further example of transmitting energy and data via a transformer is provided by US5206540 A.

### DESCRIPTION OF THE INVENTION

It is an objective of the invention to provide a more accurate and/or flexible method for transmitting a signal via a transformer, which is also used for energy transfer.

This objective is achieved by the subject-matter of the independent claims. Further exemplary embodiments are evident from the dependent claims and the following description.

An aspect of the invention , as defined by the independent claims, relates to a control device for controlling a power semiconductor device. The control device may be seen as gate driver device and/or gate driver system, which may be part of a power semiconductor module or power electronic building block. The power semiconductor device may comprise one or more power semiconductor switches and/or switches, their electrical interconnections, sensors and/or a cooling plate.

In general, the power semiconductor switches and/or the power semiconductor device may be interconnected to an electrical converter with 2-level or 3-level topology with and without a DC link.

According to an embodiment of the invention, the control device comprises a primary side control unit, a secondary side control unit and a transformer.

The primary side control unit may be adapted for receiving a control signal from a superordinated controller and for generating a binary primary side switching signal for the power semiconductor device. The control signal may encode switching time instants for one or more power semiconductor devices, which may be switched simultaneously or differently. The superordinated controller may be a central controller of an electrical converter. A binary signal may be a signal with two values, such as 0 and 1.

The secondary side control unit may be adapted for generating a gate signal for the power semiconductor device from the switching signal, which was transmitted via the transformer.

The transformer may be adapted for transferring electrical energy from the primary side control unit to the secondary side control unit and for transferring the primary side switching signal from the primary side control unit to the secondary side control unit. The transformer may be a so-called pulse transformer optimized for transmitting rectangular signal pulses and/or a rectangular signal sequence. It is not necessary, that the turn ratio of the windings of the transformer is different from 1. The transformer also may be seen as a galvanically separated electromagnetic transmitter and/or may be seen as a galvanically separated inductive coupling device, which has two galvanically separated but inductive coupled windings.

Due to the transformer, the primary side control unit and the secondary side control unit may be galvanically separated from each other.

The primary side control unit may comprise a voltage modulation unit for modulating an input voltage of the transformer, such that the primary side switching signal is encoded into the input voltage. The input voltage may be the primary side voltage of the transformer. Basically, the voltage modulation unit may connect a primary winding of the transformer with a DC voltage source and/or DC power supply and may disconnect the primary winding therefrom.

The voltage modulation may be performed such that the input voltage is a signal sequence comprising rising edges encoding a first value of the primary side switching signal and falling edges encoding a second value of the primary side switching signal. The first value may be 1 and the second value may be 0, or vice versa. The voltage modulation may result in a rectangular signal. A rising edge may be a step from a lower voltage to a higher voltage and a falling edge may be a step from a higher voltage to a lower voltage.

The secondary side control unit may comprise a power supply unit adapted for generating electrical power from an output voltage of the transformer for supplying the secondary side control unit. For example, the power supply unit may comprise a rectifier, which generates a DC voltage from the output voltage of the transformer. The output voltage may be a secondary side voltage of the transformer, which may be generated in a secondary winding of the transformer.

Furthermore, the secondary side control unit may comprise a voltage decoder unit for extracting (or decoding) a secondary side switching signal from the output voltage by detecting the rising edges and the falling edges in the output voltage and for generating the gate signal from the secondary side switching signal.

The control device may transfer signals and energy via a single transformer. Furthermore, the signals are encoded in a way, which allows to transmit signals faster and more accurate, as, for example, compared with modulation of a width of the voltage pulses of the input voltage. In such a way, the control device also may be beneficially used in both low voltage and medium voltage applications, for example in a range of power semiconductor types between 1.2 kV and 6.5 kV. Here, low voltage may refer to a blocking voltage of power semiconductors of less than 1.7 kV. Medium voltage may refer to a blocking voltage of power semiconductors of more than 1.7 kV. Thus, the control device may be used for low voltage and medium voltage converter systems, which allows a unification and standardisation of many types of converter systems.

According to an embodiment of the invention, the rising edges and the falling edges are delayed with respect to a change of the primary side switching signal, such that the secondary side switching signal has a constant delay with respect to the primary side switching signal. It may be that the rising edges and falling edges are generated with a specific frequency and/or regularly. The generation of jitter may be prevented by moving the time instant of the rising edge or the falling edge indicating a change of the switching signal, such that a constant delay is generated with respect to the primary side switching signal.

According to an embodiment of the invention, switching times, switching states and/or switching transitions may be numerical encoded into the primary side switching signal. It may be that the switching signal transmitted via the transformer encode codes and/or values, when the power semiconductor device has to be switched. These codes may be translated into the gate signal for the power semiconductor device by the secondary side control unit.

Alternatively, it may be that the time instants of the switching signal encoded into the input voltage correspond to time instants of the gate signal.

According to an embodiment of the invention, in a configuration mode, the primary side control unit is adapted for sending configuration data to the secondary side control unit via the voltage modulation unit. This configuration data may comprise information, when and how to switch the power semiconductor device based on the switching signal. It may contain information about gate voltages, gate currents and/or a shape of these quantities applied to one or more power semiconductor switches of the power semiconductor device.

According to an embodiment of the invention, the secondary side control unit comprises a load modulation unit for modulating a load on a secondary side of the transformer, such that a secondary side signal is encoded into a secondary side transformer current. The control device may be adapted for bidirectional data transfer. The secondary side signal may be a binary signal. The load may be modulated by connecting a resistor in parallel with the secondary winding and disconnecting the load from the resistor.

The primary side control unit may comprise a current decoder unit for extracting (or decoding) the secondary side signal from a primary side transformer current. For example, the current decoder may compare the primary side current with a threshold.

The secondary side signal may be encoded by frequency-shift keying, phase-shift keying and/or amplitude-shift keying. In this case, the transfer rate from the secondary side to the primary side may be much lower as the transfer rate from the primary side to the secondary side. However, different types of data, such as several measurement signals, may be transferred from the secondary side to the primary side.

According to an embodiment of the invention, the secondary side control unit is adapted for receiving measurement and/or diagnostic signals from the power semiconductor device. Measurement signals may comprise a voltage, a current and/or a temperature. Diagnostic signals may comprise information on an overcurrent, a semiconductor desaturation, and in general states and error codes. These signals may be received analogly and/or digitally and, in the first case, may be digitized by the secondary side control unit.

The load modulation unit may encode the measurement and/or diagnostic signals, for example by shift keying.

According to an embodiment of the invention, the secondary side control unit is adapted for sending diagnostic data to the primary side control unit via the load modulation unit. The secondary side control unit may generate diagnostic data from the measurement signals received from the power semiconductor device.

In general, the measurement signals, measurement data and diagnostic data may be sent from the secondary side control unit to the primary side control unit and from there to the superordinated controller. This may enable a better usage of the overall converter system, since power reserves may be used. Also, predictive maintenance may be enabled, since future problems and/or errors may be predicted. An analysis of measurement and diagnostics data from converter operation may be used for improving future systems.

According to an embodiment of the invention, the secondary side control unit is adapted for generating at least two different gate signals from the switching signal for different semiconductor devices. It may be that the secondary side control unit has a demultiplexer, which separates two signals from the switching signal. It also may be that the gate signals are encoded via numerical codes into the switching signal and that the secondary side control unit generates the gate signals by evaluating the codes.

According to an embodiment of the invention, the control device further comprises an adapter unit for generating and/or distributing a gate voltage and a gate current to be applied to a power semiconductor switch from the gate signal. The adapter unit may be used for adapting the control device to different types of systems and/or power semiconductors. For example, the control device may be adapted to 2-level or 3-level topology and/or to a parallel connection of power semiconductor devices.

According to an embodiment of the invention, a gate voltage amplitude and/or gate current amplitude are configurable by the secondary side control unit. Also, a shape of the gate voltage and/or the gate voltage current may be configurable. The gate voltage amplitude, the current voltage amplitude and/or the shapes of these quantities may be configurable in software.

Alternatively, the gate voltage and the gate current may be generated by the secondary side control unit based on the secondary side switching signal.

According to an embodiment of the invention, the adapter unit is adapted for sending a measurement signal to the secondary side control unit. The adapter unit may receive analog and/or digital signals from the power semiconductor device, may optionally process them and may send them to the secondary side control unit.

According to an embodiment of the invention, the adapted unit is adapted for generating and/or distributing at least two gate voltages for at least two power semiconductor switches. It may be that the adapter unit generates the gate signals for parallel power semiconductor switches.

According to an embodiment of the invention, the adapter unit is adapted for sending at least two measurement signals from the at least two power semiconductor switches to the secondary side control unit. It also may be that the adapter unit bundles the measurement signals from the power semiconductor switches, it supplies with gate signals.

According to an embodiment of the invention, the secondary side control unit and the adapter unit are interconnected via a flexible electrical conductor, such as an electrical cable and/or a flexible printed circuit board, for transmitting the gate signal and/or a measurement signal. Due to the galvanic separation provided by the transformer, the adapter unit may be on the same potential as the secondary side control unit.

According to an embodiment of the invention, the control device further comprises a plurality of transformers and a secondary side control unit for each transformer, wherein the primary side control unit generates different switching signals for the secondary side control units, which are transmitted via the respective transformer.

The control device maybe seen as a multi-channel gate driver. With such a control device, the number of components of an electrical converter and the efforts for assembly may be reduced.

The primary side control unit may comprise a signal-multiplexer-demultiplexer for separating the control signal from the superordinated controller into a switching signal for each power semiconductor device connected to the primary side control units.

The signal-multiplexer-demultiplexer may be part of a computing unit of the primary side control unit, which also may perform local protection functions for all connected power semiconductor modules. These protection functions may be performed independently from the superordinated controller.

According to an embodiment of the invention, the primary side control unit comprises an optical receiver unit adapted for decoding an optical signal via a fibre-optics line from the superordinated controller. With a multi-channel control device, the number of fibre optic lines may be reduced. Furthermore, in medium voltage application, an additional separation of electric potentials between different control devices may be achieved.

According to an embodiment of the invention, the primary side control unit comprises a measurement unit for receiving a measurement signal from sensors directly connected to the primary side control unit. A computing unit of the primary side control unit may digitize these measurement signals, such as voltage, current and/or temperature. The primary side control unit also may be adapted for sending the measurement signal to the superordinated controller.

A further aspect of the invention relates to a method of transmitting energy and a data signal via a transformer. The method may be performed by a data and energy transmission system, which comprises a primary side control unit, a secondary side control unit and a transformer.

According to an embodiment of the invention, the method comprises: modulating an input voltage of the transformer, such that a binary primary side signal is encoded into rising edges and falling edges of the input voltage; transforming the input voltage into an output voltage by the transformer; generating electrical power from an output voltage of the transformer by rectifying the output voltage; and detecting the rising edges and the falling edges in the output voltage for generating a secondary side signal.

The input voltage may be modulated, such that it is a signal sequence, which is composed of a positive voltage level, a neutral voltage level and a negative voltage level. The modulated input voltage may be a rectangular voltage, i.e. the input voltage may instantly change between the positive voltage level, the neutral voltage level and the negative voltage level.

The primary side control unit may comprise a three point modulator, which connects and disconnects the primary winding of the transformer to and from a constant voltage source. The voltage source may be connected in a positive and negative direction to the primary winding. A computing unit of the primary side control unit may control the three point modulator to encode the primary side signal.

A first value of the primary side signal, such as 1, may be encoded with a rising edge from the negative voltage level to the positive voltage level and a second value of the primary side signal, such as 0, may be encoded with a falling edge from the positive voltage level to the negative voltage level.

The output voltage of the transformer may have substantially the same shape and/or form as the input voltage.

The secondary side control unit may comprise a power supply unit with a rectifier, which rectifies the output voltage. The rectified output voltage may be stored in an energy storage of the secondary side control unit and/or may be used for powering the secondary side control unit.

The secondary side control unit may comprise a voltage decoder unit, which is adapted for detecting rising and falling edges, which have a zero crossing of the output voltage. A detected rising edge and falling edge may be associated with a value. The secondary side signal may be on the value of the latest detected rising edge or falling edge.

When the primary side signal stays on a value, rising edges or falling edges may be separated by a neutral signal sequence, wherein a neutral signal sequence comprises at least one transition between the negative voltage level and the neutral voltage level and at least one separate transition between the neutral voltage level and the positive voltage level. In other words, neutral signal sequences do not comprise rising edges and falling edges between the positive voltage level and the negative voltage level.

One or more time intervals, where the input voltage stays zero, may be included between rising edges and falling edges between the positive voltage level and the negative voltage level. Several time intervals may be separated by transitions between the positive and negative voltage level and the neutral voltage level, such that no rising and falling edges are generated. In such a way, energy may be transferred through the transformer without generating rising edges and falling edges.

After a change of the primary side signal between the first value and the second value, a rising edge or a falling edge indicating the change of the primary side signal may be delayed with respect to the change of the primary side signal, such that the secondary side signal has a constant delay with respect to the primary side signal,

According to an embodiment of the invention, the rising edge or the falling edge is delayed by varying a duration of a neutral signal sequence before the rising edge or the falling edge. The duration of the neutral signal sequence may be adapted by adapting times between transitions between the positive, neutral and negative voltage level.

According to an embodiment of the invention, the rising edge or the falling edge is delayed by varying a time, in which a neutral signal sequence before the rising edge or the falling edge is on the neutral voltage level.

According to an embodiment of the invention, the rising edge or the falling edge is delayed by varying a time, in which a neutral signal sequence before the rising edge or the falling edge is on the positive voltage level and/or the negative voltage level.

The one or more time intervals, where the input voltage stays zero, is on the positive voltage level and/or is on the negative voltage level, may be adjusted in length, such that a constant delay between the primary side signal and the secondary side signal is generated. This may reduce jitter in the secondary side signal.

According to an embodiment of the invention, a neutral signal sequence comprises a transition from the negative voltage level or the positive voltage level to the neutral voltage level and a separate transition from the neutral voltage level to the positive voltage level or the negative voltage level. In other words, a neutral signal sequence does not comprise a rising edge or a falling edge and/or a zero crossing of the voltage. The voltage decoder unit of the secondary side does not detect any changes during a neutral signal sequence.

Between the rising edges, falling edges and transitions from or to the neutral voltage, the input voltage comprises time intervals of constant voltage, in which the input voltage is either at the positive voltage, the neutral voltage or the negative voltage.

In a simple case, the neutral signal sequence between a rising edge and a falling edge comprises solely one time interval, in which the input voltage is at the neutral voltage. However, more than one such time intervals may be included into a neutral signal sequence.

According to an embodiment of the invention, the neutral signal sequence comprises at least two transitions to the positive voltage level and/or the negative voltage level.

Two or more time intervals at which the input voltage is at the neutral voltage level may be separated by one or more time intervals, in which the input voltage is at the positive voltage level or at the negative voltage level. Furthermore, the time intervals, in which the input voltage is at the positive voltage level or at the negative voltage level, may alternate with each other.

According to an embodiment of the invention, the number of positive voltage levels and negative voltage levels, transitioned to between two consecutive rising edges or two consecutive falling edges, is even. This, optionally together with positive and negative time intervals of the same length, may be used for preventing a magnetic saturation of the transformer.

According to an embodiment of the invention, the time intervals in which the input voltage stays in the positive voltage level and/or the negative voltage level have equal length. However, time intervals, in which the input voltage stays at the neutral voltage level, may have different lengths to control the time instants of the rising and falling edges.

According to an embodiment of the invention, when the primary side signal changes, a rising edge and a directly following falling edge indicating the signal change are separated by a neutral signal sequence. Vice versa, when the primary side signal changes, a falling edge and a directly following rising edge indicating the signal change may be separated by a neutral signal sequence. One or more time intervals, in which the input voltage is at the neutral voltage, may be included between a rising edge and a falling edge.

Alternatively, a rising edge and a falling edge may be connected with a time interval, in which the input voltage is solely at the positive voltage level. Also, a falling edge and a rising edge may be connected with a time interval, in which the input voltage is solely at the negative voltage level.

According to an embodiment of the invention, when the primary side signal stays on a value, a rising edge or a falling edge together with a following neutral signal sequence is regularly repeated. This may result in a sectional stationary pulse frequency, which may provide a continuous power supply through the transformer.

It may be that the time, in which the input voltage is at the positive voltage level, and the time, in which the input voltage is at the negative voltage level, are equal. This may result in a symmetric magnetic flux in the transformer.

According to an embodiment of the invention, the secondary side signal is set to the first value, when a rising edge is detected in the output voltage, and the secondary side signal is set to the second value, when a falling edge is detected in the output voltage. The voltage decoder unit may translate the output voltage into the secondary side signal. This may be performed with edge detection of edges crossing the neutral voltage level.

According to an embodiment of the invention, the method further comprises: encoding a second binary primary side signal into the input voltage, wherein a first value of the second primary side signal corresponds to repeating a rising edge and/or a falling edge within a time limit and a second value of the second primary side signal corresponds to omitting rising edges and a falling edge within the time limit.

It is possible to transmit a second signal via the transformer from the primary side control unit to the secondary side control unit. This may be performed by interrupting a repetitive generation of the rising edges and falling edges. When the second primary side signal is on a first value, such as 0, the voltage modulator may generate the input voltage as described above. When the second primary side signal is on a second value, such as 1, the generation of the rising and falling edges may be stopped.

A further decoder unit of the secondary control unit may determine the time, when the last rising edge or falling edge has been detected by the voltage decoder unit. When this time is longer than a time limit, the further decoder may set a second secondary side signal to the second value. The time limit may have to be longer than the time interval, after which the rising edges or falling edges are repeated.

There are several possibilities, how the rising and falling edges may be omitted.

According to an embodiment of the invention, rising and falling edges are omitted by extending a time interval at which the input voltage is at the neutral voltage level. It also is possible that rising and falling edges are omitted by including a neutral signal sequence. In the second case, the power transfer through the transformer may be maintained.

According to an embodiment of the invention, the method further comprises: encoding a binary secondary side signal into a secondary side transformer current by modulating a load connected to the transformer; and extracting (or decoding) a further primary side signal from a primary side transformer current, for example by comparing the primary side transformer current with a threshold. It is also possible to transfer a signal from the secondary side to the primary side, i.e. from the secondary side control unit to the primary side control unit by load modulation.

The secondary side control unit may comprise a current modulator unit, which may be adapted for changing the current through the secondary winding of the transformer. When this current rises, also the current through the primary winding rises. This may be detected by a current decoder of the primary side control unit.

According to an embodiment of the invention, a first value of the secondary side signal is encoded by disconnecting a resistive load from the transformer and a second value is encoded by connecting the resistive load to the transformer. The resistive load and/or the time interval, during which the load is connected, may be chosen, such that the primary side current rises above a threshold. This may be detected by the current decoder unit of the primary side control unit.

According to an embodiment of the invention, a first value of the secondary side signal is encoded by opening a short-circuit switch and a second value is encoded by closing the short-circuit switch. This may result in comparable fast and/or high peaks in the primary side current, which may be used for encoding an error signal.

According to an embodiment of the invention, the secondary side signal is encoded by frequency-shift keying, phase-shift keying and/or amplitude-shift keying. In such a way, a rectangular signal with arbitrary time interval lengths, in which the first value or the second value is encoded, may be generated and transmitted.

A further aspect of the invention relates to a data and energy transmission system, which comprises a primary side control unit, a secondary side control unit and a transformer. The data and energy transmission system may be adapted for performing the method as described in the above and in the following.

The primary side control unit of the data and energy transmission system may comprise a voltage modulation unit for modulating an input voltage of the transformer, such that the primary side switching signal is encoded into the input voltage.

The secondary side control unit of the data and energy transmission system may comprise a voltage decoder unit for extracting a secondary side switching signal from the output voltage.

The secondary side control unit of the data and energy transmission system may comprise a load modulation unit for modulating a load on a secondary side of the transformer, such that a secondary side signal is encoded into a secondary side transformer current, wherein the secondary side signal is encoded by frequency-shift keying, phase-shift keying and/or amplitude-shift keying.

The primary side control unit of the data and energy transmission system may comprise a current decoder unit for extracting the secondary side signal from a primary side transformer current.

A further aspect of the invention relates to a control device for controlling a power semiconductor device, the control device comprising the data and energy transmission system for supplying the secondary side control unit with electrical power and for transmitting a switching signal from the primary side control unit to the secondary side control unit.

It may be that the switching signal and/or the gate signal for a power semiconductor device is encoded into rising edges and falling edges of the input voltage.

It may be that the control signal for turn-off of a power semiconductor device (such as soft-turn-of) is encoded into the input voltage of the transformer by omitting rising edges and falling edges for a time limit.

It may be that a fast error signal is encoded with load modulation into the secondary side current of the transformer, wherein the load modulation is performed with a short-circuit switch. Such an error signal may be generated, when desaturation of a semiconductor switch is detected.

It may be that one or more measurement signals are encoded with load modulation into the secondary side current of the transformer, for example by frequency-shift keying, phase-shift keying and/or amplitude-shift keying. Such measurement signals may comprise a current, a voltage, and/or a temperature of the power semiconductor device.

It has to be understood that features of the method as described in the above and in the following may be features of the control device and the data and energy transmission system as described in the above and in the following, and vice versa.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 schematically shows a control device according to an embodiment of the invention.
Fig. 2 schematically shows a secondary side part of a control device according to an embodiment of the invention.
Fig. 3 schematically shows a secondary side part of a control device according to an embodiment of the invention.
Fig. 4 schematically shows a secondary side part of a control device according to an embodiment of the invention.
Fig. 5 shows a data and energy transmission system according to an embodiment of the invention.
Fig. 6 shows a decoder unit for a data and energy transmission system according to an embodiment of the invention.
Fig. 7 shows a diagram with signals produced by the data and energy transmission system of Fig. 5.
Fig. 8 shows a diagram with signals produced by the data and energy transmission system of Fig. 5.
Fig. 9 shows a diagram with signals produced by the data and energy transmission system of Fig. 5.
Fig. 10 shows a diagram with signals produced by the data and energy transmission system of Fig. 5.
Fig. 11 shows a diagram with signals produced by the data and energy transmission system of Fig. 5.
Fig. 12 shows a diagram with signals produced by the data and energy transmission system of Fig. 5.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

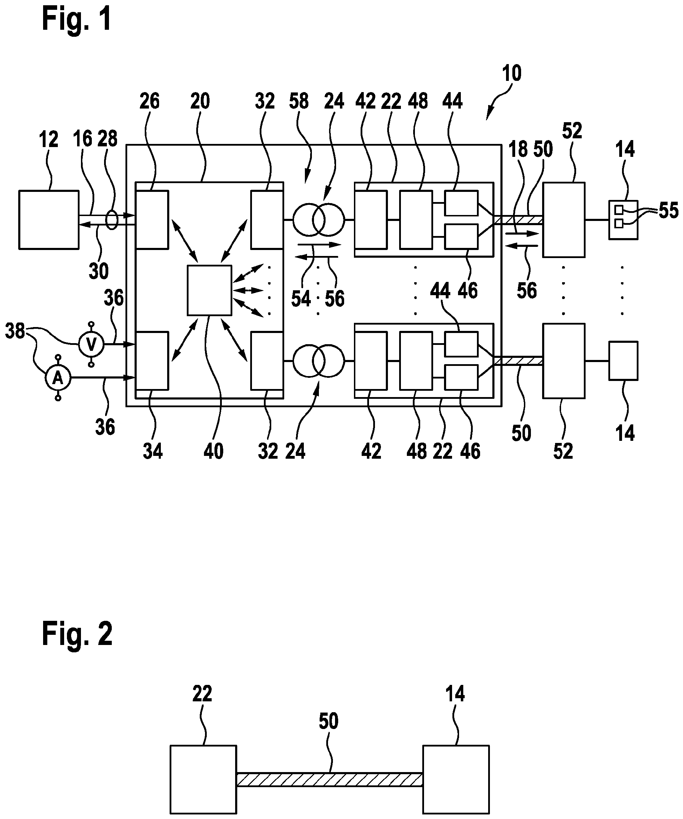

Fig. 1 shows a control device 10, which interconnects a superordinated controller 12 and several power semiconductor devices 14.

The superordinated controller 12 may be the central controller of an electric converter, which is composed of the power semiconductor devices 14. The converter may comprise a plurality of the control devices 10. The control device 10 maybe seen as multi-channel gate driver that receives a control signal 16 from the superordinated controller 12 and that generates a plurality of gate signals 18, which are supplied to the power semiconductor devices 14.

The control device 10 comprises a primary side control unit 20 and a plurality of secondary side control units 22. For each secondary side control unit 22, the control device 10 comprises a transformer 24, which is used for transferring energy from the primary side control unit 20 to the respective secondary side control unit 22 and for transmitting signals from the primary side control unit 20 to the respective secondary side control unit 22 and vice versa. In general, the transformer 24 may be seen as a galvanically separating and inductive coupling device.

It is also possible that the control device 10 has solely one secondary side control unit 22 and solely one transformer 24.

The primary side control unit 20 comprises an optical sender/receiver unit 26 for bidirectional data exchange with the superordinated controller 12. The sender/receiver unit 26 is interconnected via a fibre-optics line 28 with the superordinated controller 12. This guarantees that the potential of the primary side control unit 20 is galvanically separated from the controller 12. As already mentioned, a control signal or control data 16 may be received from the controller 12 and/or measurement and diagnostics data 30 may be sent to the controller 12. For example, switching times, switching states and/or switching transitions may be received from the controller 12.

Furthermore, the primary side control unit 20 comprises a transmission unit 32 for sending and receiving signals and sending energy via the transformer 24. In the case of a plurality of transformers 24, the primary side control unit 20 may comprise a transmission unit 32 for every transformer 24.

The primary side control unit 20 also may comprise an interface unit 34 for receiving measurement signals 36 from sensors 38, such as voltage, current and/or temperature sensors.

A computing unit 40 of the primary side control unit 20 may control and coordinate the units 26, 32, 34 and, for example, may multiplex and demultiplex signals sent between the controller 12 and the secondary side control units 22. For example, the computing unit 40 may process the sensor signals 36, such that they can be sent with the optical sender/receiver unit 26 to the superordinated controller 12. Furthermore, the computing unit 40 may process the control signal 16 to extract a switching signal 54, which is then sent with the respective transmission unit 32 to the respective secondary side control unit 22.

The secondary side control unit 22 comprises a transmission unit 42 for sending and receiving signals and receiving energy via the transformer 24, a semiconductor control unit 44 for controlling the power semiconductor device 14, an interface unit 46 for receiving measurement signals from the power semiconductor device 14 and a computing unit 48 for coordinating the units 42, 44, 46 with each other.

The semiconductor control unit 44 and the interface unit 46 may be connected via a flexible electrical conductor 50 with an adapter unit 52 that converts a gate signal 18 from the semiconductor control unit 44 into a gate voltage and a gate current to be supplied to one or more power semiconductor switches of the power semiconductor device 14. It also may be that the adapter unit 52 solely distributes the gate signal 18 to one or more power semiconductor switches of the power semiconductor device 14.

The adapter unit 52 may be programmable and a gate voltage amplitude, a gate current amplitude and/or a shape of these quantities may be set in the adapter unit 52 via configuration data. This configuration data may be supplied from the semiconductor control unit 44. It also may be that the semiconductor control unit 44 is programmable and that a gate voltage amplitude, a gate current amplitude and/or a shape of these quantities may be set in the semiconductor control unit 44 via configuration data.

It has to be noted that each power semiconductor device 14 may comprise one or more semiconductor switches 55, which may receive the gate voltage and the gate current. The adapter unit 52 and/or the semiconductor control unit 44 may generate different gate voltages and/or different gate currents for different semiconductor switches 55.

Conversely, the adapter unit 52 may receive measurement signals from the power semiconductor device 14 and may transform this into measurement signals 56 that may be processed by the interface unit 46. In summary, the adapter unit 52 may adapt the control device 10 to different types and/or topologies of power semiconductor devices 14.

The transmission unit 42 may receive the switching signal 54, the computing unit 48 may process the switching signal to generate the gate signal 18, which is sent to the adapter unit 52. Furthermore, the interface unit 46 may receive a measurement signal 56, which may be processed by the computing unit 48 and sent with the transmission unit 42 to the primary side control unit 20. Also this measurement signal 56 may be sent to the subordinated controller 12 via the optical sender/receiver unit 26.

Fig. 2 shows, that a secondary side control unit 22 may be directly connected to a power semiconductor device 14. An adapter unit 52 may be not necessary. The gate voltage and the gate current may be directly generated by the semiconductor control unit 44.

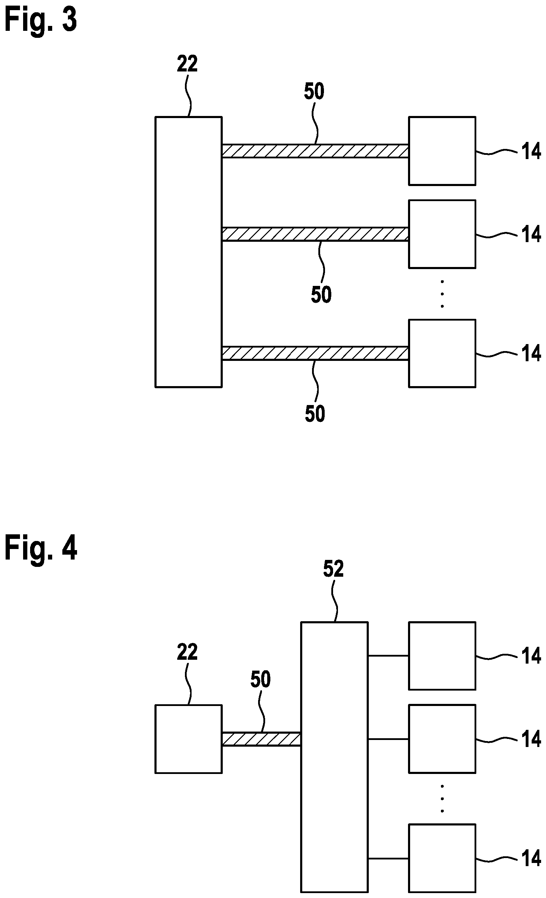

Fig. 3 shows that a secondary side control unit 22 may be directly connected to a plurality of power semiconductor devices 14. The gate voltages and the gate currents for these power semiconductor devices 14 may be directly generated by the semiconductor control unit 44.

Fig. 4 shows that an adapter unit 52 may be connected to a plurality of power semiconductor devices 14. In this case, the gate voltages and the gate currents for these power semiconductor devices 14 may be generated by the adapter unit 52 or may be distributed to the power semiconductor devices 14 by the adapter unit 52.

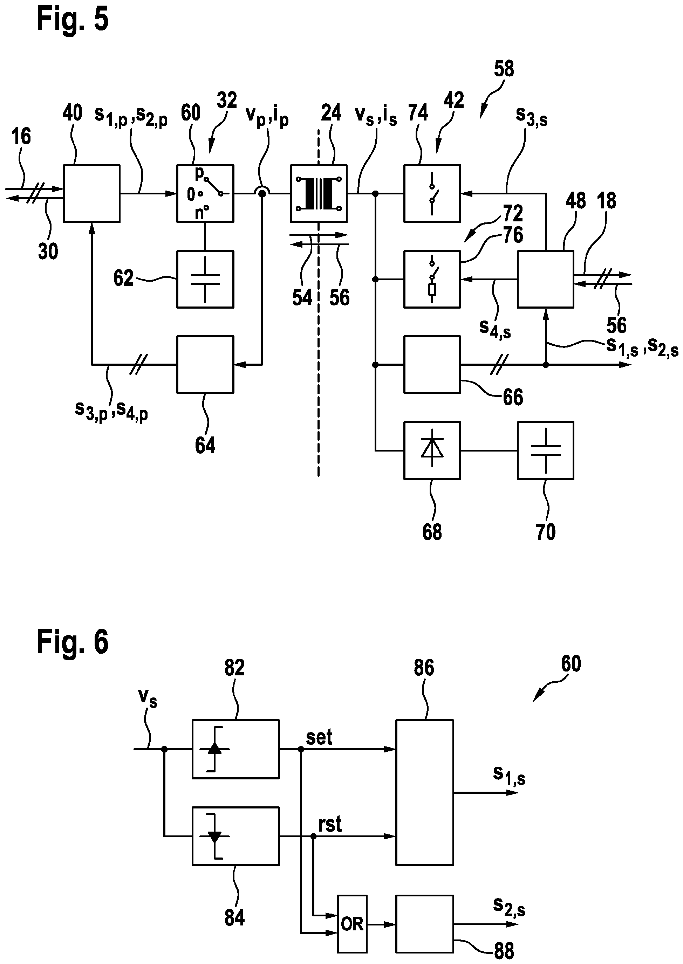

Fig. 5 shows the data and energy transmission system 58 that is implemented in the control device of Fig. 1 in more detail.

The system 58 comprises the primary side computing unit 40, the primary side transmission unit 32, the transformer 24, the secondary side transmission unit 42 and the secondary side computing unit 48.

The primary side transmission unit 32 comprises a voltage modulation unit 60, a primary side energy storage 62 and an optional current decoder unit 64.

The secondary side transmission unit 42 comprises a voltage decoder unit 66, a power supply unit 68 and a secondary side energy storage 70. Optionally, the secondary side transmission unit 42 may comprise a load modulation unit 72 with a short-circuit switch 74 and/or a switchable resistive load 76.

The primary side computing unit 40 receives the control signal and/or control data 16 from the superordinated controller 12 and generates a primary side switching signal s_{1,p}, which is applied to the voltage modulation unit 60, which modulates an input voltage vₚ of the transformer 24, such that the primary side switching signal s_{1,p} is encoded into the input voltage vₚ.

The primary side switching signal s_{1,p} may encode gate signals, i.e. the transitions times, directly. However, it also may be that switching states are numerical encoded into the primary side switching signal s_{1,p} and/or that switching times are numerical encoded into the primary side switching signal s_{1,p}. The secondary side control unit 22 then may determine the gate signal 18 from these information. It also may be that the secondary side control unit 22 is adapted for generating at least two different gate signals 18 from the secondary side switching signal s_{1,s} for different semiconductor devices 14.

It also may be that in a configuration mode, the primary side control unit 20 sends configuration data to the secondary side control unit 22 via the primary side signal s_{1,p}. Such configuration data may include gate voltages, gate currents, a shape of these quantities, switching time delays, etc.

The voltage modulation unit 60 may be a three-point modulator, which connects the primary side energy storage 62 with the primary winding of the transformer 24 in different ways. The primary winding may be connected in a positive and negative way to the primary side energy storage 62 and may be disconnected from it. This generates an input voltage vₚ with a positive voltage level p, a neutral voltage level 0 and a negative voltage level n.

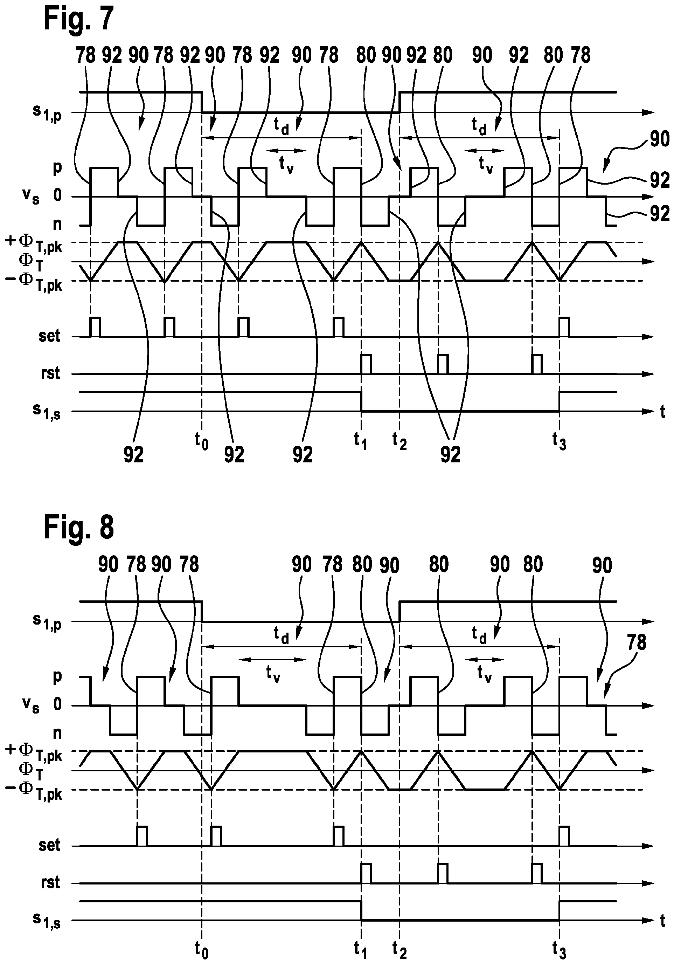

The input voltage vₚ may be seen as a signal sequence, which comprises rising edges 78 encoding a first value of the primary side switching signal s_{1,p} and falling edges 80 encoding a second value of the primary side switching signal s_{1,p}. This will be explained in more detail with respect to Fig. 7.

The voltage decoder unit 66 of the secondary side transmission unit 42 extracts a secondary side switching signal s_{1,s} from the output voltage vₛ by detecting the rising edges 78 and the falling edges 80 in the output voltage vₛ. The one or more gate signals 18 then may be generated by the secondary side computing unit 48 from the secondary side switching signal s_{1,s}.

Fig. 6 shows a possible implementation of the voltage decoder unit 66 in more detail. The voltage decoder unit 66 comprises a rising edge detector 82, a falling edge detector 84 and a latch module 86. When a rising edge 78 is detected, a set input of the latch module 86 is activated and the latch module outputs the first value, such as 1, of the secondary side switching signal s_{1,s}. When a falling edge 78 is detected, a reset input of the latch module 86 is activated and the latch module 86 outputs the second value, such as 0, of the secondary side switching signal s_{1,s}.

Optionally, the voltage decoder unit 66 comprises a missing pulse detector 88, which may generate a second secondary side signal s_{2,s} from the output voltage vₛ, which will be explained below.

Returning to Fig. 5, the power supply unit 68 of the secondary side transmission unit 42 generates electrical power from an output voltage vₛ of the transformer 24, which may be stored in the secondary side energy storage 70 and which may be used for supplying the secondary side control unit 22.

The computing unit 48 also may receive measurement and/or diagnostic signals 56 from the one or more power semiconductor devices 14. It may be that the computing unit 48 transforms the measurement and/or diagnostic signals 56 into secondary side signal s_{3,s} and/or s_{4,s}, which are then applied to the load modulation unit 72, which modulates the secondary side current iₛ, through the secondary winding of the transformer 24. For example, diagnostics data and/or measurement data may be sent to the primary side transmission unit 32.

The secondary side current iₛ may be modulated by closing the short-circuit switch 74, which is connected in parallel with the secondary winding, for specific time intervals or by connecting the resistive load 76 for specific time intervals in parallel with the secondary winding. This may result in current peaks in the secondary side current iₛ and also the primary side current iₛ, which may be detected by the current decoder unit 64, which extracts a corresponding primary side signal s_{3,p}, s_{4,p} from a primary side transformer current iₚ. This signal s_{3,p}, s_{4,p} may be evaluated by the primary side computing unit 40 and/or may be sent to the superordinated controller 12.

A method of transmitting energy and a data signal via the transformer 24 with the system 58 shown in Fig. 5 will now be explained with respect to Fig. 7 to 12.

In general, the input voltage vₚ of the transformer 24 is modulated, such that a binary primary side signal s_{1,p} is encoded into rising edges 78 and falling edges 80 of the input voltage vₚ. the input voltage vₚ is transformed into an output voltage vₛ by the transformer 24 and the rising edges 78 and the falling edges 80 are detected in the output voltage vₛ for generating a secondary side signal s_{1,s}.

As shown in Fig. 7, the input voltage vₚ is modulated, such that it is a signal sequence, which is composed of time intervals, where the voltage is at a positive voltage level p, a neutral voltage level 0 and a negative voltage level n.

A first value (such as 1) of the primary side signal s_{1,p} is encoded with a rising edge 78 from the negative voltage level n to the positive voltage level n and a second value (such as 0) of the primary side signal s_{1,p} is encoded with a falling edge 80 from the positive voltage level p to the negative voltage level n.

The signal sequence of the input voltage vₚ also comprises transitions 92 from the negative voltage level n or the positive voltage level p to the neutral voltage level 0 and vice versa and transitions 92 from the neutral voltage level 0 to the positive voltage level p or the negative voltage level n, and vice versa.

The transitions 92 may be seen as small transitions or small rising and falling edges, wherein the rising edges 78 and falling edges 80 may be seen as large transitions or large rising and falling edges. The transitions 92 do not have a crossing of the neutral voltage level 0, while the rising edges 78 and the falling edges 80 have such a crossing.

The time intervals, in which the input voltage vₚ is on the positive voltage level p or on the negative voltage level n, all may have the same length. This length may be chosen, such that the magnetization Φ_{T} of the transformer 24 stays within preselected bounds +Φ_{T,pk} and -Φ_{T,pk}. The time intervals, in which the input voltage vₚ is on the neutral voltage level 0, may have varying lengths, which may be used for moving and/or delaying rising edges 78 and falling edges 80.

When the primary side signal s_{1,p} stays on a value, rising edges 78 or falling edges 80 are separated by a neutral signal sequence 90, which comprises at least one transition 92 from the negative voltage level n or the positive voltage level p to the neutral voltage level 0 and at least one transition 92 from the neutral voltage level 0 to the positive voltage level p or the negative voltage level n.

After a change of the primary side signal s_{1,p} between the first value and the second value, a rising edge 78 or a falling edge 80 indicating the change of the primary side signal s_{1,p} is delayed with respect to the change of the primary side signal s_{1,s}, such that the secondary side signal s_{1,p} has a constant delay time t_{d} with respect to the primary side signal s_{1,p}. To achieve this, the corresponding rising edge 78 or the falling edge 80 is delayed by varying a time tᵥ, in which a neutral signal sequence 90 before the rising edge 78 or the falling edge 80 is on the neutral voltage level 0.

The constant delay time t_{d} may be between 100 nanoseconds and 10 microseconds. This may be achieved by generating the first rising edge 78 or the first falling edge 80 indicating a new value of the primary side signal s_{1,p} is generated exactly after the delay time t_{d}.

A movement of rising edges 78 and falling edges 80 may be achieved by shortening or lengthening time intervals, in which the input voltage vₚ is on the neutral voltage level 0.

Fig. 7 and Fig. 8 show two examples, how these time intervals may be adapted for achieving a constant delay time t_{d}.

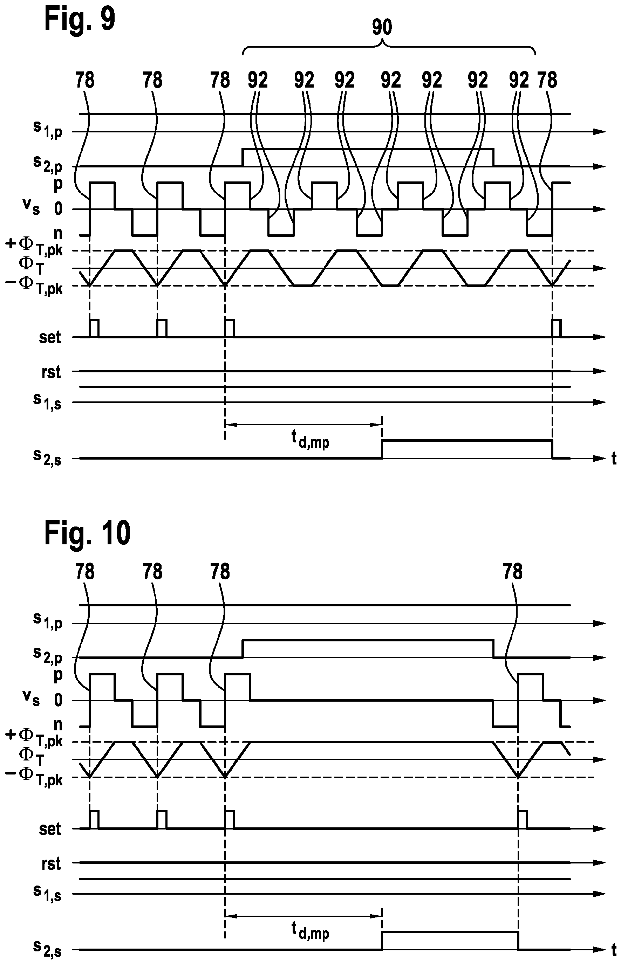

Furthermore, neutral signal sequences 90 with more than one time interval, in which the input voltage vₚ is on the neutral voltage level 0, may be inserted. Fig. 9 shows such a neutral signal sequence 90, however, for delaying two neighbouring rising edges 78.

In such a way, the pulse frequency used for transmitting energy need not have an influence on the time resolution of the delay time t_{d}. The jitter of the constant delay time t_{d} does not depend on the pulse frequency used for transmitting energy.

Two consecutive rising edges 78, two consecutive falling edges 80 and/or a rising edge 78 neighboring a falling edge 80 may be separated by a neutral signal sequence 90, which has one or more time intervals, in which the input voltage vₚ is on the neutral voltage level 0. In general, a neutral signal sequence 90 may be a signal sequence having only small transitions 92.

It may be that a neutral signal sequence 90 comprises at least two transitions 92 to the positive voltage level p and/or the negative voltage level n.

In the following, a time interval, in which the input voltage vₚ is on the positive voltage level p, is called positive time interval, a time interval, in which the input voltage vₚ is on the negative voltage level n, is called negative time interval, and a time interval, in which the input voltage vₚ is on the neutral voltage level 0, is called neutral time interval.

A neutral signal sequence 90 may now be composed of one or more neutral time intervals. It may be that in a neutral signal sequence 90, a positive time interval is followed by a neutral time interval, which is followed by a negative time interval, which is followed by the neutral time interval. This pattern may be repeated. It also may be that in a neutral signal sequence 90, a negative time interval is followed by a neutral time interval, which is followed by a positive time interval, which is followed by the neutral time interval. This pattern may be repeated.

The number of positive voltage levels p and negative voltage levels n, transitioned to between two consecutive rising edges 78 or two consecutive falling edges 80, i.e. the number of positive time intervals and negative time intervals, is even. This may keep the magnetization of the transformer 24 in balance.

It also may be that, when the primary side signal s_{1,p} changes, a rising edge 78 and a directly following falling edge 80 are separated by a neutral signal sequence 90. Such a neutral sequence 90 may have an odd number of positive time intervals and negative time intervals for keeping the magnetization of the transformer 24 in balance.

In the case, when the primary side signal s_{1,p} does not change, a pattern composed of a rising edge 78 or a falling edge 80 followed by a neutral signal sequence 90 may be regularly repeated. When the primary side signal s_{1,p} stays on a value, a rising edge 78 or a falling edge 80 together with a following neutral signal sequence 90 is regularly repeated. This may result in a sectional stationary pulse frequency, which provides a continuous energy transmission to the secondary side.

The sum of the durations of the positive time intervals and the sum of the durations of the negative time intervals may be equal and/or constant within a moving time window, to balance the magnetization of the transformer 24.

As indicated in Fig. 7 to 11 with the signals set and rst, which are produced by the edge detectors 82, 84, the secondary side signal s_{1,p} is reconstructed from the rising edges and falling edges in the output voltage vₛ, which depending on the transfer properties of the transformer 24 may have nearly the same shape as the input voltage vₚ. The secondary side signal s_{1,s} is set to the first value, when a rising edge 78 is detected in the output voltage vₛ and is kept on this value. Also, when a falling edge 80 is detected in the output voltage vₛ, the secondary side signal s_{1,s} is set to the second value and kept on this value.

As shown in Fig. 9 and 10 it is possible to encode a second binary primary side signal s_{2,p} into the input voltage vₚ. In general, a first value, such as 0, of the second primary side signal s_{2,p}corresponds to repeating a rising edge 78 and/or a falling edge 80 within a time limit t_{d,mp}. A second value, such as 1, of the second primary side signal s_{2,p} corresponds to omitting rising edges 78 and falling edges 80 within the time limit t_{d,mp}. The second primary side signal s_{2,p} may be transmitted priorised with respect to the primary side signal s_{1,p}. Whenever there is a conflict in the two encoding schemes, the encoding scheme of the second primary side signal s_{2,p} may be maintained.

For decoding the second primary side signal s_{2,p} into a second secondary side signal s_{2,s}, the decoder unit 66 may be provided with a missing pulse detector 88, which comprises a timer, which is reset, when a rising edge 78 or falling edge 80 is detected. The timer may have a running time equal to the time limit t_{d,mp}. When the timer is running, the second secondary side signal s_{2,s} is set to the first value, such as 0. When the timer has run out, the second secondary side signal s_{2,s} is set to the second value, such as 1.

The time limit t_{d,mp} may have to be longer than a time, in which the rising edges 78 and the falling edges 80 are repeated and/or the time between two neighbouring rising and falling edges.

As shown in Fig. 9, rising edges 78 and falling edges 80 may be omitted by including a neutral signal sequence 90, which is longer than the time limit t_{d,mp}.

As is shown in Fig. 10, rising edges 78 and falling edges 80 also may be omitted by extending a time at which the input voltage vₚ is at the neutral voltage level, i.e. by extending a neutral time interval.

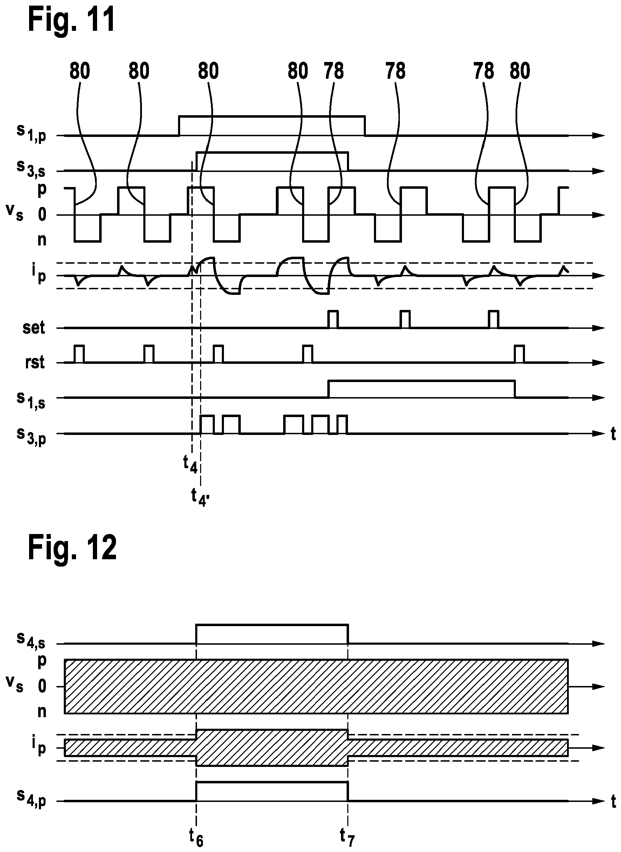

Fig. 11 and 12 show, how a binary secondary side signal s_{3,s}, s_{4,s} may be encoded into the secondary side transformer current iₛ by modulating a load 74, 76 connected to the transformer 24. Fig. 11 and 12 show the primary side transformer current iₚ, which may have the same or nearly the same shape as the secondary side transformer current iₛ.

A first value of the secondary side signal s_{3,s} may be encoded by disconnecting a resistive load 76 from the transformer 24 and a second value may be encoded by connecting the resistive load 76 to the transformer 24. Alternatively, a first value of the secondary side signal s_{3,s}, s_{4,s} is encoded by opening a short-circuit switch 74 and a second value is encoded by closing the short-circuit switch 74.

As shown in Fig. 11, by choosing the load 76 appropriately or by closing the switch 74, the primary side transformer current iₚ may then exceed a threshold, during times, when the load 76 is connected or the switch 74 is closed. This generates a pulse-like primary side signal s_{3,p}.

This may be used for extracting a primary side signal s_{3,p} from a primary side transformer current iₚ by comparing the primary side transformer current iₚ with the threshold. The primary side signal s_{3,p} may be used for transmitting an error value to the primary side.

As shown in Fig. 12, in the same way, a secondary side signal s_{4,s} may be encoded by frequency-shift keying, phase-shift keying and/or amplitude-shift keying. For the keying, the pulse generated by connecting the load 76 or by closing the switch 74, as shown in Fig. 11, may be used.

In this case, a primary side signal s_{4,p} having the same shape as the secondary side signal s_{4,s} may be generated.

The secondary side signal s_{4,s} may be used for transmitting of measurement signals, system states and/or more detailed error messages.

The primary side signals s_{3,p} and s_{4,p} may be decoded by the current decoder unit 64, which measures the primary side transformer current iₚ and demodulates it according to the chosen modulation schema.

While the invention has been illustrated and described in detail in the drawings and foregoing description, such illustration and description are to be considered illustrative or exemplary and not restrictive; the invention is not limited to the disclosed embodiments, and is defined by the independent claims.

In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: control device
- 12: superordinated controller
- 14: power semiconductor device
- 16: control signal
- 18: gate signal
- 20: primary side control unit
- 22: secondary side control unit
- 24: transformer
- 26: optical sender/receiver unit
- 28: fibre-optics line
- 30: measurement and diagnostics data
- 32: transmission unit
- 34: interface unit
- 36: measurement signal
- 38: sensor
- 40: computing unit
- 42: transmission unit
- 44: semiconductor control unit
- 46: interface unit
- 48: computing unit
- 50: flexible electrical conductor
- 52: adapter unit
- 54: switching signal
- 55: semiconductor switch
- 56: measurement signal
- 58: data and energy transmission system
- 60: voltage modulation unit
- 62: primary side energy storage
- 64: current decoder unit
- 66: voltage decoder unit
- 68: power supply unit
- 70: secondary side energy storage
- 72: load modulation unit
- 74: short-circuit switch
- 76: switchable resistive load
- 78: rising edge
- 80: falling edge
- p: positive voltage level
- 0: neutral voltage level
- n: negative voltage level
- vₚ: input voltage, primary side transformer voltage
- vₛ: output voltage, secondary side transformer voltage
- iₚ: primary side transformer current
- iₛ: secondary side transformer current
- s_{1,p}: primary side (switching) signal
- s_{1,s}: secondary side (switching) signal
- set: set signal
- rst: reset signal
- 82: rising edge detector
- 84: falling edge detector
- 86: latch module
- 88: missing pulse detector
- 90: neutral signal sequence
- 92: transition
- Φ_{T}: magnetization of transformer
- +Φ_{T,pk}: upper bound for magnetization
- -Φ_{T,pk}: lower bound for magnetization
- t_{d}: delay time
- tᵥ: varying time
- t_{d,mp}: time limit
- s_{2,p}: second primary side signal
- s_{2,s}: second secondary side signal
- s_{2,p}: third primary side signal
- s_{2,s}: third secondary side signal
- s_{2,p}: fourth primary side signal
- s_{2,s}: fourth secondary side signal

## Claims

1. A method of transmitting energy and a data signal via a transformer (24), the method comprising:
modulating an input voltage (vₚ) of the transformer (24), such that a binary primary side signal (s_{1,p}) is encoded into rising edges (78) and falling edges (80) of the input voltage (vₚ);
transforming the input voltage (vₚ) into an output voltage (vₛ) by the transformer;
detecting the rising edges (78) and the falling edges (80) in the output voltage (vₛ) for generating a secondary side signal (si,s);
wherein the input voltage (vₚ) is modulated, such that it is a signal sequence, which is composed of a positive voltage level (p), a neutral voltage level (0) and a negative voltage level (n);
wherein a first value of the primary side signal (s_{1,p}) is encoded with a rising edge (78) from the negative voltage level (n) to the positive voltage level (p) and a second value of the primary side signal (s_{1,p}) is encoded with a falling edge (80) from the positive voltage level (p) to the negative voltage level (n);
wherein, when the primary side signal (s_{1,p}) stays on the first value, rising edges (78) from the negative voltage level (n) to the positive voltage level (p) are separated by a neutral signal sequence (90), and when the primary side signal stays on the second value, falling edges (80) from the positive voltage level (p) to the negative voltage level (n) are separated by a neutral signal sequence (90);
wherein a rising edge (78) from the negative voltage level (n) to the positive voltage level (p) together with a following neutral signal sequence (90) is regularly repeated when the primary side signal (s_{1,p}) stays on the first value, and a falling edge (80) from the positive voltage level (p) to the negative voltage level (n) together with a following neutral signal sequence (90) is regularly repeated when the primary side signal (s_{1,p}) stays on the second value; wherein a neutral signal sequence (90) comprises at least one transition (92) between the negative voltage level (n) and the neutral voltage level (0) and at least one separate transition (92) between the neutral voltage level (0) and the positive voltage level (p); wherein the number of positive voltage levels (p) and negative voltage levels (n) between two consecutive rising edges (78) from the negative voltage level (n) to the positive voltage level (p) is even and the number of positive voltage levels (p) and negative voltage levels (n) between two consecutive falling edges (80) from the positive voltage level (p) to the negative voltage level (n) is even.

2. The method of claim 1,
wherein after a change of the primary side signal between the first value and the second value, a rising edge or a falling edge indicating the change of the primary side signal is delayed, such that the secondary side signal has a constant delay (t_{d}) with respect to the primary side signal, wherein
the rising edge (78) or the falling edge (80) is delayed by varying a time, in which a neutral signal sequence (90) before the rising edge (78) or the falling edge (80) is on the neutral voltage level (0); and/or
the rising edge (78) or the falling edge (80) is delayed by varying a time, in which a neutral signal sequence (90) before the rising edge (78) or the falling edge (80) is on the positive voltage level (p) and/or the negative voltage level (n).

3. The method of claim 1 or 2,
wherein a neutral signal sequence (90) comprises a transition (92) from the negative voltage level (n) or the positive voltage level (p) to the neutral voltage level (0) and a separate transition (92) from the neutral voltage level (0) to the positive voltage level (p) or the negative voltage level (n); and/or
wherein the neutral signal sequence (90) comprises at least two transitions (92) to the positive voltage level (p) and/or the negative voltage level (n).

4. The method of one of the previous claims,
wherein the time intervals in which the input voltage (vₚ) stays in the positive voltage level (p) and/or the negative voltage level (n) have equal length.

5. The method of one of the previous claims,
wherein, when the primary side signal (s_{1,p}) changes, a rising edge (78) and a directly following falling edge (80) indicating the signal change are separated by a neutral signal sequence (90); and/or
wherein, when the primary side signal (s_{1,p}) changes, a falling edge (80) and a directly following rising edge (78) indicating the signal change are separated by a neutral signal sequence (90).

6. The method of one of the previous claims,
wherein the secondary side signal (s_{1,s}) is set to the first value, when a rising edge (78) is detected in the output voltage (vₛ) and the secondary side signal (s_{1,s}) is set to the second value, when a falling edge (80) is detected in the output voltage (vs).

7. The method of one of the previous claims, further comprising:
encoding a second binary primary side signal (s_{2,p}) into the input voltage (vₚ);
wherein a first value of the second primary side signal (s_{2,p}) corresponds to repeating a rising edge (78) and/or a falling edge (80) within a time limit (t_{d,mp});
wherein a second value of the second primary side signal (s_{2,p}) corresponds to omitting rising edges (78) and falling edges (80) within the time limit (t_{d,mp}).

8. The method of claim 7,
wherein rising edges (78) and falling edges (80) are omitted by extending a time at which the input voltage (vₚ) is at the neutral voltage level; and/or
wherein rising edges (78) and falling edges (80) are omitted by including a neutral signal sequence (90).

9. The method of one of the previous claims, further comprising:
encoding a binary secondary side signal (s_{3,s}, s_{4,s}) into a secondary side transformer current (iₛ) by modulating a load (74, 76) connected to the transformer (24);
extracting a further primary side signal (s_{3,p}, s_{4,p}) from a primary side transformer current (iₚ).

10. The method of claim 9,
wherein a first value of the secondary side signal (s_{3,s}, s_{4,s}) is encoded by disconnecting a resistive load (76) from the transformer (24) and a second value is encoded by connecting the resistive load (76) to the transformer (24); and/or
wherein a first value of the secondary side signal (s_{3,s}, s_{4,s}) is encoded by opening a short-circuit switch (74) and a second value is encoded by closing the short-circuit switch (74).

11. The method of claim 9 or 10,
wherein the secondary side signal (s_{3,s}, s_{4,s}) is encoded by frequency-shift keying, phase-shift keying and/or amplitude-shift keying.

12. A data and energy transmission system (58), comprising:
a primary side control unit (20);
a secondary side control unit (22);
a transformer (24);
wherein the data and energy transmission system (58) is adapted for performing the method of one of the previous claims.

13. A control device (10) for controlling a power semiconductor device (14), the control device (10) comprising the data and energy transmission system (58) of claim 12 for supplying the secondary side control unit (22) with electrical power and for transmitting a switching signal (54) from the primary side control unit (20) to the secondary side control unit (22).

## Patentansprüche

1. Verfahren zum Übertragen von Energie und einem Datensignal über einen Transformator (24), wobei das Verfahren umfasst:
Modulieren einer Eingangsspannung (vₚ) des Transformators (24), so dass ein binäres primärseitiges Signal (s_{1,p}) in ansteigende Flanken (78) und abfallende Flanken (80) der Eingangsspannung (vₚ) codiert wird;
Umwandeln der Eingangsspannung (vₚ) in eine Ausgangsspannung (vₛ) durch den Transformator;
Detektieren der ansteigenden Flanken (78) und der abfallenden Flanken (80) in der Ausgangsspannung (vₛ) zum Generieren eines sekundärseitigen Signals (s_{1,s});
wobei die Eingangsspannung (vₚ) moduliert wird, so dass sie eine Signalfolge ist, die sich aus einem positiven Spannungspegel (p), einem neutralen Spannungspegel (0) und einem negativen Spannungspegel (n) zusammensetzt;
wobei ein erster Wert des primärseitigen Signals (s_{1,p}) mit einer ansteigenden Flanke (78) vom negativen Spannungspegel (n) zum positiven Spannungspegel (p) codiert ist und ein zweiter Wert des primärseitigen Signals (s_{1,p}) mit einer abfallenden Flanke (80) vom positiven Spannungspegel (p) zum negativen Spannungspegel (n) codiert ist;
wobei, wenn das primärseitige Signal (s_{1,p}) auf dem ersten Wert bleibt, ansteigende Flanken (78) vom negativen Spannungspegel (n) zum positiven Spannungspegel (p) durch eine neutrale Signalfolge (90) getrennt sind, und wenn das primärseitige Signal auf dem zweiten Wert bleibt,
abfallende Flanken (80) vom positiven Spannungspegel (p) zum negativen Spannungspegel (n) durch eine neutrale Signalfolge (90) getrennt sind;
wobei eine ansteigende Flanke (78) vom negativen Spannungspegel (n) zum positiven Spannungspegel (p) zusammen mit einer folgenden neutralen Signalfolge (90) regelmäßig wiederholt wird, wenn das primärseitige Signal (s_{1,p}) auf dem ersten Wert bleibt, und eine abfallende Flanke (80) vom positiven Spannungspegel (p) zum negativen Spannungspegel (n) zusammen mit einer folgenden neutralen Signalfolge (90) regelmäßig wiederholt wird,
wenn das primärseitige Signal (s_{1,p}) auf dem zweiten Wert bleibt; wobei eine neutrale Signalfolge (90) wenigstens einen Übergang (92) zwischen dem negativen Spannungspegel (n) und dem neutralen Spannungspegel (0) und wenigstens einen getrennten Übergang (92) zwischen dem neutralen Spannungspegel (0) und dem positiven Spannungspegel (p) umfasst; wobei die Anzahl positiver Spannungspegel (p) und negativer Spannungspegel (n) zwischen zwei aufeinanderfolgenden ansteigenden Flanken (78) vom negativen Spannungspegel (n) zum positiven Spannungspegel (p) geradzahlig ist und die Anzahl positiver Spannungspegel (p) und negativer Spannungspegel (n) zwischen zwei aufeinanderfolgenden abfallenden Flanken (80) vom positiven Spannungspegel (p) zum negativen Spannungspegel (n) geradzahlig ist.

2. Verfahren nach Anspruch 1,
wobei nach einer Änderung des primärseitigen Signals zwischen dem ersten Wert und dem zweiten Wert eine ansteigende Flanke oder eine abfallende Flanke, was die Änderung des primärseitigen Signals angibt, verzögert wird, so dass das sekundärseitige Signal eine konstante Verzögerung (t_{d}) in Bezug auf das primärseitige Signal aufweist, wobei
die ansteigende Flanke (78) oder die abfallende Flanke (80) durch Variieren einer Zeit verzögert wird, in der eine neutrale Signalfolge (90) vor der ansteigenden Flanke (78) oder der abfallenden Flanke (80) auf dem neutralen Spannungspegel (0) ist; und/oder die ansteigende Flanke (78) oder die abfallende Flanke (80) durch Variieren einer Zeit verzögert wird, in der eine neutrale Signalfolge (90) vor der ansteigenden Flanke (78) oder der abfallenden Flanke (80) auf dem positiven Spannungspegel (p) und/oder dem negativen Spannungspegel (n) ist.

3. Verfahren nach Anspruch 1 oder 2,
wobei eine neutrale Signalfolge (90) einen Übergang (92) vom negativen Spannungspegel (n) oder vom positiven Spannungspegel (p) zum neutralen Spannungspegel (0) und einen getrennten Übergang (92) vom neutralen Spannungspegel (0) zum positiven Spannungspegel (p) oder negativen Spannungspegel (n) umfasst; und/oder wobei die neutrale Signalfolge (90) wenigstens zwei Übergänge (92) zum positiven Spannungspegel (p) und/oder zum negativen Spannungspegel (n) umfasst.

4. Verfahren nach einem der vorstehenden Ansprüche, wobei die Zeitintervalle, in denen die Eingangsspannung (vₚ) auf dem positiven Spannungspegel (p) und/oder dem negativen Spannungspegel (n) bleibt, die gleiche Länge haben.

5. Verfahren nach einem der vorstehenden Ansprüche, wobei, wenn sich das primärseitige Signal (s_{1,p}) ändert, eine ansteigende Flanke (78) und eine direkt folgende abfallende Flanke (80), was die Signaländerung angibt, durch eine neutrale Signalfolge (90) getrennt sind;
und/oder
wobei, wenn sich das primärseitige Signal (s_{1,p}) ändert, eine abfallende Flanke (80) und eine direkt folgende ansteigende Flanke (78), was die Signaländerung angibt, durch eine neutrale Signalfolge (90) getrennt sind.

6. Verfahren nach einem der vorstehenden Ansprüche, wobei das sekundärseitige Signal (s_{1,s}) auf den ersten Wert gesetzt wird, wenn eine ansteigende Flanke (78) in der Ausgangsspannung (vₛ) detektiert wird, und das sekundärseitige Signal (s_{1,s}) auf den zweiten Wert gesetzt wird, wenn eine abfallende Flanke (80) in der Ausgangsspannung (vₛ) detektiert wird.

7. Verfahren nach einem der vorstehenden Ansprüche, ferner umfassend:
Codieren eines zweiten binären primärseitigen Signals (s_{2,p}) in die Eingangsspannung (vₚ);
wobei ein erster Wert des zweiten primärseitigen Signals (s_{2,p}) dem Wiederholen einer ansteigenden Flanke (78) und/oder einer abfallenden Flanke (80) innerhalb einer Zeitbegrenzung (t_{d,mp}) entspricht;
wobei ein zweiter Wert des zweiten primärseitigen Signals (s_{2,p}) dem Auslassen ansteigender Flanken (78) und abfallender Flanken (80) innerhalb der Zeitbegrenzung (t_{d,mp}) entspricht.

8. Verfahren gemäß Anspruch 7,
wobei ansteigende Flanken (78) und abfallende Flanken (80) ausgelassen werden, indem eine Zeit erweitert wird, in der die Eingangsspannung (vₚ) auf dem neutralen Spannungspegel ist; und/oder
wobei ansteigende Flanken (78) und abfallende Flanken (80) ausgelassen werden, indem eine neutrale Signalfolge (90) einbezogen wird.

9. Verfahren nach einem der vorstehenden Ansprüche, ferner umfassend:
Codieren eines binären sekundärseitigen Signals (s_{3,s}, s_{4,s}) in einen sekundärseitigen Transformatorstrom (iₛ) durch Modulieren einer Last (74, 76), die an dem Transformator anliegt (24);
Extrahieren eines weiteren primärseitigen Signals (s_{3,p}, s_{4,p}) aus einem primärseitigen Transformatorstrom (iₚ).

10. Verfahren gemäß Anspruch 9,
wobei ein erster Wert des sekundärseitigen Signals (s_{3,s}, s_{4,s}) codiert wird, indem eine resistive Last (76) von dem Transformator (24) getrennt wird und ein zweiter Wert codiert wird, indem die resistive Last (76) an den Transformator (24) angelegt wird; und/oder wobei ein erster Wert des sekundärseitigen Signals (s_{3,s}, s_{4,s}) codiert wird, indem ein Kurzschlussschalter (74) geöffnet wird, und ein zweiter Wert codiert wird, indem der Kurzschlussschalter (74) geschlossen wird.

11. Verfahren nach Anspruch 9 oder 10,
wobei das sekundärseitige Signal (s_{3,s}, s_{4,s}) durch Frequenzumtastung, Phasenumtastung und/oder Amplitudenumtastung codiert wird.

12. Daten- und Energieübertragungssystem (58), umfassend:
eine primärseitige Steuereinheit (20);
eine sekundärseitige Steuereinheit (22);
einen Transformator (24);
wobei das Daten- und Energieübertragungssystem (58) für das Durchführen des Verfahrens nach einem der vorstehenden Ansprüche ausgelegt ist.

13. Steuervorrichtung (10) zum Steuern einer Leistungshalbleitervorrichtung (14), wobei die Steuervorrichtung (10) das Daten- und Energieübertragungssystem (58) nach Anspruch 12 umfasst, um die sekundärseitige Steuereinheit (22) mit elektrischem Strom zu versorgen und um ein Schaltsignal (54) von der primärseitigen Steuereinheit (20) an die sekundärseitige Steuereinheit (22) zu übertragen.

## Revendications

1. Procédé de transmission d'énergie et d'un signal de données par l'intermédiaire d'un transformateur (24), le procédé comprenant :
la modulation d'une tension d'entrée (vₚ) du transformateur (24), de telle sorte qu'un signal côté primaire binaire (s_{1,p}) soit encodé avec des bords montants (78) et des bords descendants (80) de la tension d'entrée (vₚ) ;
la transformation de la tension d'entrée (vₚ) en une tension de sortie (vₛ) par le transformateur ;
la détection des bords montants (78) et des bords descendants (80) dans la tension de sortie (vₛ) pour générer un signal côté secondaire (s_{1,s}) ;
dans lequel la tension d'entrée (vₚ) est modulée, de telle sorte qu'elle soit une séquence de signal, composée d'un niveau de tension positif (p), d'un niveau de tension neutre (0) et d'un niveau de tension négatif (n) ;
dans lequel une première valeur du signal côté primaire (s_{1,p}) est encodée avec un bord montant (78) du niveau de tension négatif (n) au niveau de tension positif (p) et une seconde valeur du signal côté primaire (s_{1,p}) est encodée avec un bord descendant (80) du niveau de tension positif (p) au niveau de tension négatif (n) ;
dans lequel, lorsque le signal côté primaire (s_{1,p}) reste sur la première valeur, des bords montants (78) du niveau de tension négatif (n) au niveau de tension positif (p) sont séparés par une séquence de signal neutre (90), et quand le signal côté primaire reste sur la seconde valeur, des bords descendants (80) du niveau de tension positif (p) au niveau de tension négatif (n) sont séparés par une séquence de signal neutre (90) ;
dans lequel un bord montant (78) du niveau de tension négatif (n) au niveau de tension positif (p) ainsi qu'une séquence de signal neutre suivante (90) sont régulièrement répétés lorsque le signal côté primaire (s_{1,p}) reste sur la première valeur, et un bord descendant (80) du niveau de tension positif (p) au niveau de tension négatif (n) ainsi qu'une séquence de signal neutre suivante (90) sont régulièrement répétés quand le signal côté primaire (s_{1,p}) reste sur la seconde valeur ; dans lequel une séquence de signal neutre (90) comprend au moins une transition (92) entre le niveau de tension négatif (n) et le niveau de tension neutre (0) et au moins une transition séparée (92) entre le niveau de tension neutre (0) et le niveau de tension positif (p) ; dans lequel le nombre de niveaux de tension positifs (p) et les niveaux de tension négatifs (n) entre deux bords montants consécutifs (78) du niveau de tension négatif (n) au niveau de tension positif (p) est pair et le nombre de niveaux de tension positifs (p) et de niveaux de tension négatifs (n) entre deux bords descendants consécutifs (80) du niveau de tension positif (p) au niveau de tension négatif (n) est pair.

2. Procédé selon la revendication l,
dans lequel après un changement du signal côté primaire entre la première valeur et la seconde valeur, un bord montant ou un bord descendant indiquant le changement du signal côté primaire est retardé, de telle sorte que le signal côté secondaire ait un retard constant (t_{d}) relativement au signal côté primaire, dans lequel
le bord montant (78) ou le bord descendant (80) est retardé en faisant varier une durée pendant laquelle une séquence de signal neutre (90) avant le bord montant (78) ou le bord descendant (80) est au niveau de tension neutre (0) ; et/ou
le bord montant (78) ou le bord descendant (80) est retardé en faisant varier une durée pendant laquelle une séquence de signal neutre (90) avant le bord montant (78) ou le bord descendant (80) est au niveau de tension positif (p) et/ou au niveau de tension négatif (n).

3. Procédé selon la revendication 1 ou 2,
dans lequel une séquence de signal neutre (90) comprend une transition (92) du niveau de tension négatif (n) ou du niveau de tension positif (p) au niveau de tension neutre (0) et une transition séparée (92) du niveau de tension neutre (0) au niveau de tension positif (p) ou au niveau de tension négatif (n) ; et/ou
dans lequel la séquence de signal neutre (90) comprend au moins deux transitions (92) au niveau de tension positif (p) et/ou au niveau de tension négatif (n) .

4. Procédé selon l'une des revendications précédentes,
dans lequel les intervalles de temps durant lesquels la tension d'entrée (vₚ) reste au niveau de tension positif (p) et/ou au niveau de tension négatif (n) sont de même longueur.

5. Procédé selon l'une des revendications précédentes,
dans lequel, lorsque le signal côté primaire (s_{1,p}) change, un bord montant (78) et un bord descendant (80) indiquant le changement de signal sont séparés par une séquence de signal neutre (90) ; et/ou
dans lequel, lorsque le signal côté primaire (s_{1,p}) change, un bord descendant (80) et un bord montant directement suivant (78) indiquant le changement de signal sont séparés par une séquence de signal neutre (90) .

6. Procédé selon l'une des revendications précédentes,
dans lequel le signal côté secondaire (s_{1,s}) est réglé sur la première valeur, lorsqu'un bord montant (78) est détecté dans la tension de sortie (vₛ) et le signal côté secondaire (s_{1,s}) est réglé sur la seconde valeur, lorsqu'un bord descendant (80) est détecté dans la tension de sortie (vₛ).

7. Procédé selon l'une des revendications précédentes, comprenant en outre :
l'encodage d'un second signal côté primaire binaire (s_{2,p}) dans la tension d'entrée (vₚ) ;
dans lequel une première valeur du second signal côté primaire (s_{2,p}) correspond à une répétition d'un bord montant (78) et/ou d'un bord descendant (80) en-deçà d'une limite de temps (t_{d,mp}) ;
dans lequel une seconde valeur du second signal côté primaire (s_{2,p}) correspond à une omission de bords montants (78) et de bords descendants (80) en-deçà de la limite de temps (t_{d,mp}).

8. Procédé selon la revendication 7,
dans lequel des bords montants (78) et des bords descendants (80) sont omis en prolongeant une durée pendant laquelle la tension d'entrée (vₚ) est au niveau de tension neutre ; et/ou
dans lequel des bords montants (78) et des bords descendants (80) sont omis en incluant une séquence de signal neutre (90).

9. Procédé selon l'une des revendications précédentes, comprenant en outre :
l'encodage d'un signal côté secondaire binaire (s_{3,s}, s_{4,s}) dans un courant de transformateur côté secondaire (iₛ) en modulant une charge (74, 76) connectée au transformateur (24) ;
l'extraction d'un autre signal côté primaire (s_{3,p}, s_{4,p}) d'un courant de transformateur côté primaire (iₚ).

10. Procédé selon la revendication 9,
dans lequel une première valeur du signal côté secondaire (s_{3,s}, s_{4,s}) est encodée en déconnectant une charge résistive (76) du transformateur (24) et une seconde valeur est encodée en connectant la charge résistive (76) au transformateur (24); et/ou
dans lequel une première valeur du signal côté secondaire (s_{3,s}, s_{4,s}) est encodée en ouvrant un interrupteur de court-circuit (74) et une seconde valeur est encodée en fermant l'interrupteur de court-circuit (74) .

11. Procédé selon la revendication 9 ou 10,
dans lequel le signal côté secondaire (s_{3,s}, s_{4,s}) est encodé par modulation par déplacement de fréquence, modulation par déplacement de phase et/ou modulation par déplacement d'amplitude.

12. Réseau de transmission de données et d'énergie (58), comprenant :
une unité de commande côté primaire (20) ;
une unité de commande côté secondaire (22) ;
un transformateur (24) ;
le système de transmission de données et d'énergie (58) étant conçu pour réaliser le procédé selon l'une des revendications précédentes.

13. Dispositif de commande (10) pour commander un dispositif à semi-conducteurs de puissance (14), le dispositif de commande (10) comprenant le système de transmission de données et d'énergie (58) selon la revendication 12 pour alimenter en énergie électrique l'unité de commande côté secondaire (22) et transmettre un signal de commutation (54) de l'unité de commande côté primaire (20) à l'unité de commande côté secondaire (22).
